# EUROPEAN PATENT APPLICATION

(11) **EP 0 798 571 A2**
(43) Date of publication of application: **01.10.1997**
(21) Application number: 97104048.0
(22) Date of filing: 11.03.1997
(51) Int. Cl.: G02B 1/10

(54) **Method of forming striped pattern of thin film material on board and masking apparatus used in the method**

(30) Priority: 26.03.1996 JP 69740/96
(71) Applicant: KUREHA CHEMICAL INDUSTRY CO., LTD., Chuo-ku Tokyo (JP)
(72) Inventor: Akiyama, Kenji, Saitama (JP); Shouji, Masuhiro, Iwaki-shi, Fukushima (JP); Ogihara, Takeo, Iwaki-shi, Fukushima (JP); Sakagami, Teruo, Iwaki-shi, Fukushima (JP)
(74) Representative: Weisert, Annekäte, Dipl.-Ing. Dr.-Ing.

(57) **Abstract**

As a method of manufacturing an optical low pass filter by evaporating thin film material on the surface of a board to form striped pattern of thin film material having mountains and valleys formed at a fixed pitch on the surface of the board, a method of arranging wire on the surface of the board at the fixed pitch and evaporating thin film material while using the wire used as a mask. However, in this method, it is difficult to put the wire on the surface of the board at the accurate pitch with the wire stretched on the board.

In a masking apparatus of the present invention, grooved rods (12a) and (12b) including V-grooves (15a) having V-shaped section and formed at an equal pitch are fixed on both sides of holding members (10). A tension exerting member (21) for exerting resilient force on wire (L) is disposed above a surface opposite to a surface of the holding base (11) on which the board is held. The tension exerting member (21) is disposed in a place different from place of the holding members (10) in which the grooved rods (12a) and (12b) are fixed on so as not to exert the tension on the grooved rods (12a) and (12b). The wire (L) passes on the tension exerting member (21) to be suspended between the grooved rods (12a) and (12b) and is wound on the holding members (10) spirally. The wire (L) is wound exactly in the V-grooves (15a) of the grooved rods (12a) and (12b). Furthermore, when the tension is exerted on the wound wire (L) by the tension exerting member (21), the grooved rods (12a) and (12b) are not moved and accordingly the V-grooves (15a) are not moved from the original positions thereof. Accordingly, the wound wire (L) is put on the surface of the board (1) at the accurate pitch tautly while the wound wire (L) is held in the V-grooves (15a) exactly.

## Description

### BACKGROUND Of THE INVENTION

### FIELD OF THE INVENTION

The present invention relates to a forming method of striped pattern and a masking apparatus used in implementation of the method capable of forming the striped pattern made of thin film on the surface of a board by the evaporation or ion etching method so that the section of the striped pattern of thin film is formed into regular ruggedness in the process of fabricating an optical low pass filter or the like.

### PRIOR ART

For example, a color video camera for spatially sampling an object to be imaged optically to produce an imaged output employs an optical low pass filter for limiting a high frequency spatial component of the object to be imaged. An example of a structure and a forming method of this low pass filter is described in Japanese Patent Publication No. 16435/1984. The optical low pass filter described in the Publication includes a striped pattern formed of optical material such as SiO2 on the surface of an insulative board made of glass. The section of the striped pattern in the perpendicular direction to the extending direction of the pattern is formed with valleys and mountains varied regularly and curvedly and which are formed on the surface of the insulative board at a fixed pitch. The striped pattern is formed by evaporating optical material such as SiO2 onto the surface of the insulative board while using a plurality of wires disposed on the surface of the insulative board at a fixed pitch as a mask. The wires are suspended at a fixed pitch between frame rods disposed in parallel to both ends of the insulative board. A spring is disposed between ends of both the frame rods to exert the resilient force in the direction pendicular to the frame rods. The spring exerts the resilient force on the frame rods so that the frame rods are separated from each other to thereby exert predetermined tension on the wires suspended between the frame rods by the resilient force.

In this manner, the tension is exert on the wires to thereby dispose the wires along the surface of the board tautly. In the method in which thin film material is evaporated on the surface of the insulative board while using the wires as a mask and striped pattern of thin film material is formed on the surface of the insulative board, the pitch of the striped pattern is influenced by the arrangement pitch of the wires. In order to form the striped pattern at a fixed pitch, it is necessary to dispose the wires along the surface of the insulative board so that fixed tension is exerted on the wires and the arrangement pitch is set with high accuracy.

However, the frame rods are disposed movably so that the frame rods can receive the resilient force by the spring. Accordingly, it is difficult to hold the pair of frame rods on the insulative board in parallel to each other. Particularly, when there are differences in the respective tension of the plurality of wires suspended between the frame rods, it is difficult to hold both the frame rods in parallel. That is, the frame rods on which the wire is wound are extremely unstable and accordingly even when the wire is wound on the frame rods, it is difficult to dispose the wire along the surface of the insulative board at an accurate arrangement pitch.

In the Publication described above, a jig having grooves disposed at an equal pitch is disposed inside of the frame rods. The wire is put in the grooves of the jig. Accordingly, the arrangement pitch of the wound wire is determined by the jig and the wire can be arranged on the board at a fixed pitch.

However, in order to determine the pitch of the wire by the jig, the work for suspending the wires between the frame rods and fitting the wire into the separate grooves of the jig is required. Accordingly, the preparation process for evaporating optical material on the board is extremely troublesome. Furthermore, when the resilient force is given to the frame work by the spring after the wire is suspended, the wire tends to get out of the grooves of the jig if the frame rods are changed from the parallel state.

### SUMMARY OF THE INVENTION

It is an object of the present invention to form striped pattern made of thin film material on the surface of a board at a regular pitch.

Further, it is an object of the present invention to provide a masking apparatus capable of forming the striped pattern of thin film material on the surface of the board at a regular pitch.

In the masking apparatus of the present invention, the holding members include a pair of shaft members having a plurality of grooves each having V- or U-shaped section and formed at an equal pitch in a predetermined direction, and a holding base having one surface in which a place for installing a board is formed. The shaft members formed with the grooves are fixedly mounted in symmetrical positions at both sides of the holding base in parallel to each other. Further, a tens ion exerting member for exerting resilient force to separate from the holding members is disposed on a place of the holding members different from places on which the shaft members are fixedly mounted. Wire is put in the grooves of the shaft members disposed at both sides of the holding members to be suspended between both the shaft members and is wound spirally on the surface of the holding base and the tension exerting member to pass through thereon.

The tension exerting member is moved to be separated from the holding member to thereby exert tension on the wire. Since the tension exerting member is mounted in a place of the holding members different from the shaft members, the shaft members are not moved and the positions of the shaft members are not changed even if the tension exerting member is moved. Accordingly, when tension is exerted on the wire by means of the tension exerting member, the wire is not get out of the grooves of the shaft members. Thus, the tensioned wire is wound on the holding members at an equal pitch with high accuracy in conformity with the pitch of the grooves of the shaft members. Particularly, since the section of the grooves of the shaft members is V- or U-shaped, the center of the wire is coincident with the center of the grooves, so that the pitch of the wound wire is determined with high accuracy. Further, even when the diameter of the wire is changed and the width of the striped pattern is modified, the center of the wire having a different diameter is positioned in the center of the V- or U-shaped grooved with high accuracy. Accordingly, the wound wire is not shifted from its right position.

In addition, when the shaft members include the plurality of grooves having V- or U-shaped section and formed spirally, the wire can be wound on the shaft members spirally in accordance with the pitch of the grooves and can be wound on the holding members with the same tension over the whole length thereof. Accordingly, when tens ion is exerted on the wire by means of the tens ion exerting member, there is almost no difference in tension over the whole length of the wire.

Furthermore, the process of winding the wire on the holding members spirally is performed by rotating the wire feeding members and the holding members relatively and moving the wire feeding members and the holding members relatively in accordance with the pitch of the grooves of the shaft members. Thus, the winding of the wire on the holding members is made simply. Further, the wire can be wound exactly at the fixed pitch in accordance with the pitch of the grooves of the shaft members. Accordingly, it is difficult to fail in the winding operation of the wire.

After or before the winding of the wire and exertung a tension to the wire and then adjustment of the tension of the wire are completed, the board is attached or loaded in the holding members and thin film material is evaporated onto the surface of the board while using the wire as a mask, so that the striped pattern made of thin film material is formed on the surface of the board. Since the wire is arranged at the equal pitch, the pitch of mountains and valleys of the striped pattern on the surface of the board is also made fixed.

### BRIEF DESCRIPTION OF THE DRAWINGS

Fig. 1 is a perspective view showing an example of a masking apparatus of the present invention as viewed from the right side thereof;
Fig. 2 is a perspective view of the masking apparatus shown in Fig. 1 with the reverse side thereof up;
Fig. 3 is a perspective view of a winding apparatus for winding wire on holding members spirally in a process of manufacturing the masking apparatus shown in Fig. 1 and 2;
Fig. 4 is a sectional view of the masking apparatus in a process in which thin film is evaporated on a board held in the masking apparatus;
Fig. 5 is an enlarged sectional view of wire wound on the masking apparatus shown in Fig. 1 and striped pattern formed on the board using the masking apparatus;
Fig. 6 is a diagram showing an output of a probe type surface roughness meter for measuring roughness of the surface of the striped pattern of SiO2 formed on the board of glass by the evaporation method shown in the embodiment of the present invention; and
Fig. 7 is a sectional view showing the striped pattern formed on the board.

### DETAILED DESCRIPTION OF THE PREFERRED EMBODIMENTS

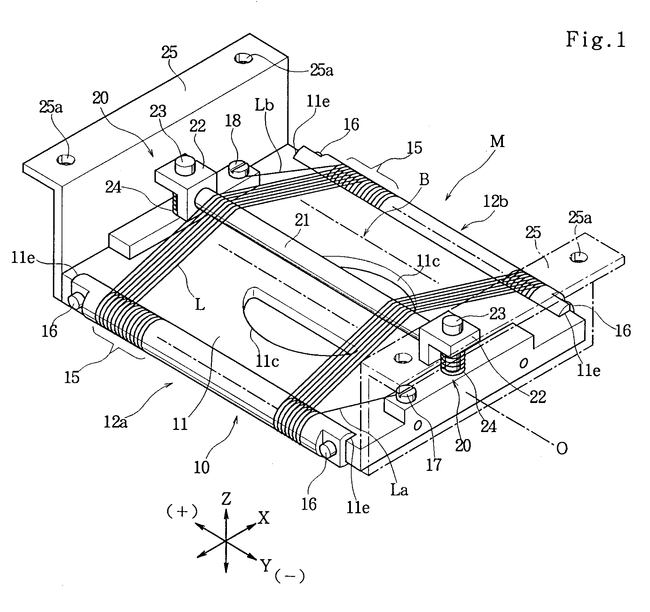

A masking apparatus (M) of the present invention comprises holding members (10) and wire (L) wound on the holding members (10). Further, the holding members (10) include a holding base (11) having a place formed on the surface in which a board is disposed and shaft members fixed on both sides of the holding base (11). In the embodiment shown in Fig. 1, grooved rods (12a) and (12b) are used as the shaft members fixed on both sides of the holding base (11). However, in the present invention, the shaft members are not limited to rods. As shown in Fig. 1, the holding members (10) includes the holding base (11), the grooved rods (12a) and (12b) fixed on both sides in the width direction (direction shown by arrow X of Fig. 1) of the holding base (11), a tension exerting member (21) disposed in the middle in the width direction (X direction) of the holding base (11) to be extended along the Y direction, and hanging members (25) fixedly mounted on bothend sides in the Y direction of the holding base (11).

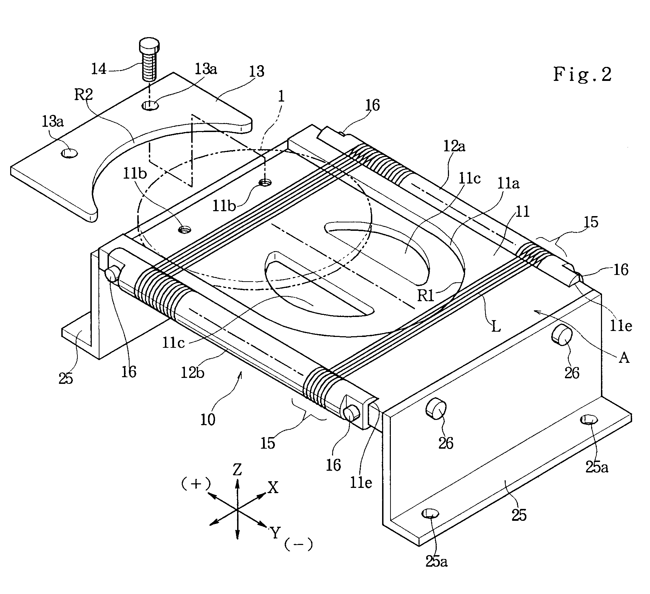

As shown in Fig. 2, the reverse side (A side) of the holding base (11) is a side opposite to an evaporation source of thin film material in the evaporation process. The evaporation is performed by a method using electronic beams or laser beams to heat the evaporation source, a spattering method or a chemical vapor deposition (CVD) method other than a resistance heating method. A cavity (11a) for holding a board (1) is formed in the reverse side (A side) of the holding base (11). One end of the cavity (11a) is curved to have a curved surface (R1) formed in a circular arc having the same curvature as that of an external peripheral surface of the disk-shaped board (1). The other end of the cavity (11a) is opened toward the end in the Y(+) direction of the holding base (11). A pair of tapped holes (11b), (11b) are formed in an inner bottom of the cavity (11a) near the opened end thereof. A holding plate (13) is inserted into the cavity (11a) from the opened end thereof in the Y direction. An end portion of the holding plate (13) facing to the board (1) is formed into a curved surface (R2) having the same curvature as that of the curved surface (R1).

The disk-shaped board (1) is inserted into the cavity (11a) from the opened end thereof and the holding plate (13) is then inserted into the cavity from the opened end in the same direction as the inserted direction of the board (1). Holes (13a), (13b) are formed on the holding plate (13) and after the holding plate (13) has been inserted into the cavity (11a), fixing screws (14) are inserted into theholes (13a), (13a). The fixing screws (14) pass through the holes (13a), (13a) and are screwed into the tapped holes (11b), (11b). In this manner, by screwing the fixing screws (14) into the tapped holes (11b), (11b), the holding plate (13) is fixed in the cavity (11a) of the holding base (11). The board (1) is held between the curved surface (R1) of the cavity (11a) and the curved surface (R2) of the holding plate (13) from both the sides thereof in the Y direction to thereby prevent the board (1) from falling out in the Y direction.

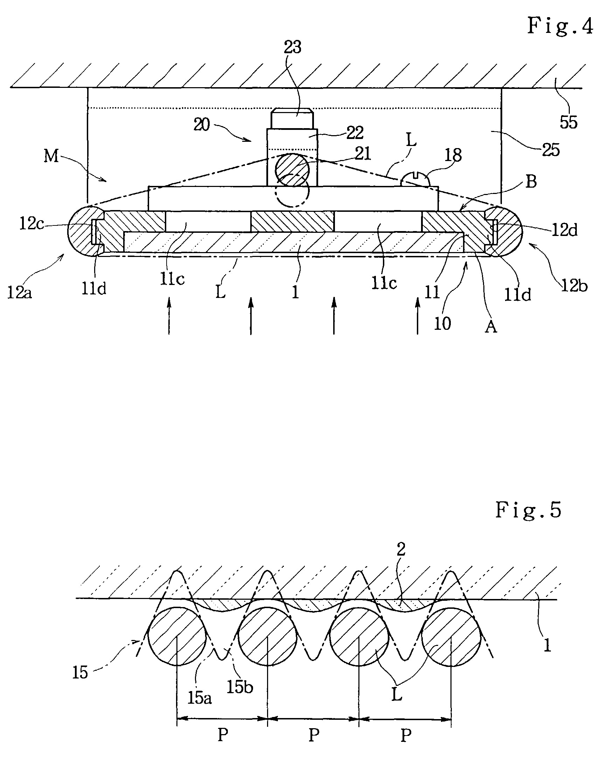

When the board (1) is held in the holding base (11) as described above, it is desirable that the board (1) is not held between the curved surfaces (R1) and (R2) by strong force so that the board (1) is not distorted. Accordingly, for example, the board (1) is desirably held between the curved surfaces (R1) and (R2) by weak force not to move in the direction shown by Z in Fig. 2. Alternatively, when the holding plate (13) is fixed on the holding base (11), small gaps are desirably formed between the outer periphery of the board (1) and the curved surface (R1) and between the outer periphery of the board (1) and the curved surface (R2). In this manner, by forming the gaps between the board (1) and the curved surfaces (R1) and (R2), the board (1) is put on the wire (L) suspended between the grooved rods (12a) and (12b) when the reverse side (A side) of the holding base (11) is directed downward in the process in which thin film is evaporated on the board (1) as shown in Fig. 4.

When the shape of the board (1) used is square or rectangular, the cavity (11a) is formed to conform to the shape of the board (1). Further, a spacer may be interposed between the bottom of the cavity (11a) and the board (1) to adjust a distance between the surface of the board (1) and the wire (L).

Further, a pair of windows (11c) are formed in the inner bottom of the cavity (11a) formed in the holding base (11) so that the pair of windows penetrate the holding base (11) toward the right side (B side).

The grooved rods (12a) and (12b) are identical with each other and a plurality of grooves are formed on the outer peripheral surface of the grooved rod at a fixed pitch in the axial direction (Y direction) spirally. The plurality of grooves are arranged to form a row of grooves (15). As shown in Fig. 1 and a following embodiment, it is desirable that the row of grooves (15) is threaded grooves formed on the basis of the unification standard. As shown in Fig. 5 in enlarged scale, the section of the individual grooves constituting the row of grooves (15) is formed into V shape. In the following description, the individual grooves shown in Fig. 5 are named V-grooves (15a). The section between adjacent V-grooves (15a) is formed into a triangularmountain (15b). The section of the individual grooves may be formed into U shape. In addition, the row of grooves (15) is not necessary to be threaded grooves.

As shown in Fig. 4, key grooves (12c) and (12d) are formed in the grooved rods (12a) and (12b), respectively. Key protrusions (11d), (11d) are protruded on both sides of the holding base (11) and are fitted into the key grooves (12c) and (12d), so that the grooved rods (12a) and (12b) are fixed on the holding base (11). Further, as shown in Fig. 1, both ends of the grooved rods (12a) and (12b) in the axial direction thereof are fitted into steps (11e) formed in the holding base (11). Thus, the grooved rods (12a) and (12b) are positioned in the axial direction (Y direction). The grooved rods (12a) and (12b) are positioned at both sides of the holding base (11) and both of the ends in the axial direction of the grooved rods (12a) and (12b) are fixed on the holding base (11) and by means of fixing screws (16).

Since the grooved rods (12a) and (12b) have the same shape and both the grooves rods (12a) and (12b) are fixedly positioned at both the sides of the holding base (11) in the respective directions, the respective V-grooves (15a) formed on both the grooved rods (12a) and (12b) are positioned symmetrically to each other at both sides of the holding base (11) in the X direction thereof. Accordingly, the V-grooves (15a) formed in the grooved rod (12a) and the V-grooves (15a) formed in the grooved rod (12b) can construct spiral loci formed continuously about the Y axis.

The tension exerting member (21) extending in the Y direction is disposed in the middle in the width direction (X direction) on the right side (B side) of the holding base (11). Both ends of the tension exerting member (21) is fixedly attached to brackets (22). Further, adjustment screws (23) are inserted into the brackets (22) and are driven into tapped holes formed in the right surface (B side) of the holding base (11). Compression springs (24) are disposed around the external peripheries of the adjustment screws (23). The compression springs (24) are interposed between the holding base (11) and the brackets (22) while being compressed. The resilient force is given to the tension exerting member (21) by the compression springs (24) so that the tension exerting member (21) is separated from the right surface (B side) of the holding base (11) in the Z direction. In addition, by driving the adjustment screws (23) into the tapped holes formed on the right surface (B side) of the holding base (11), the height position in the Z direction of the tension exerting member (21) can be adjusted. In other words, the tension exerting member (21) is attached to the holding base (11) by means of tension adjustment means (20) composed of the adjustment screws (23), the compression springs (24) and the tapped holes formed in the holding base (11).

As shown in Fig. 1, set screws (17) and (18) for fixing the wire (L) are screwed in both ends in the Y direction on the right surface (B side) of the holding base (11). A starting end (La) of the spirally wound wire (L) is fixed on the holding base (11) by means of the set screw (17) and a termination end (Lb) of the wire (L) is fixed on the holding base (11) by means of the other set screw (18).

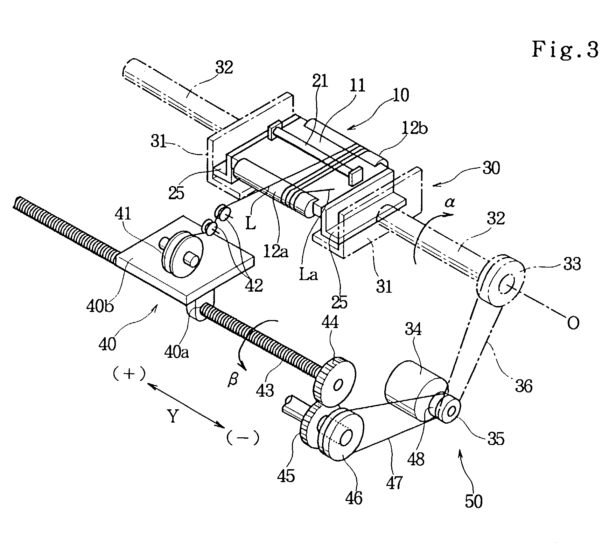

The hanging members (25) are fixedly mounted in both ends in the Y direction of the holding base (11). The hanging members (25) are L-shaped angle members and are fixed on both the ends in the Y direction of the holding base (11) by means of fixing screws (26). The hanging members (25) are extended from the right surface (B side) of the holding base (11) in the Z direction and mounting holes (25a) for fixing the holding members within a chamber of an evaporation apparatus and fixing the holding members to a holding member rotating portion (30) shown in Fig. 3 are formed in bent portions formed at upper ends of the hanging members.

Fig. 3 shows a simplified structure of a winding apparatus for winding the wire (L) on the holding members (10) spirally.

In Fig. 3, numeral (30) denotes the holding member rotating units for rotating the holding member (10). The holding member rotating units (30) includes a pair of mounting brackets (31), rotating shafts (32) fixed on the mounting brackets (31), a driven pulley (33) disposed at one end of the rotating shaft (32), a driving pulley (35) at tached to a reduced output shaft of a motor (34) and a toothed belt (36) for coupling the driven pulley (33) and the driving pulley (35). The hanging members (25) are fixedly mounted to the mounting brackets (31) by driving screws into the mounting holes (25a). The rotating shafts (32) fixed on the mounting brackets (31) are rotated about the same axis center (O). The rotating shafts (32) are supported by bearings not shown to be able to be rotated. As shown in Fig. 1, the axis center (O) of the rotating shafts (32) is set to be positioned in the center of the width in the X direction of the holding base (11) and to extend to the Y direction at the center of the thickness in the Z direction of the holding members (10).

As shown in Fig. 3, the driven pulley (toothed pulley) (33) is mounted to one end of the rotating shaft (32). Further, the driving pulley (toothed pulley) (35) mounted to the reduced output shaft of the motor (34) and the driven pulley (33) are coupled with each other by means of the toothed belt (36) so that both the pulleys (33) and (35) are rotated in synchronism with each other.

In Fig. 3, numeral (40) denotes a wire feeding members for feeding the wire (L) to the holding members (10). The wire feeding members (40) includes a movable table (40b), a raw wire roll (41) on which wire (L) is wound, a guide roll (42) for guiding the wire (L) pulled out from the raw wire roll (41), a screw shaft (43) for moving the movable table (40b). and a gear (44) mounted with an end of the screw shaft (43).

The movable table (40b) can be moved in the Y direction by means of a guide rail not shown. The raw wire roll (41) on which the wire (L) is wound is placed on the movable table (40b) and is supported to be rotated with a fixed load while being braked. Further, the guide roll (42) for guiding the wire (L) pulled out from the raw wire roll (41) is disposed on the movable table (40b).

An tapped hole (40a) is formed on the bottom of the movable table (40b). A screw shaft (43) is screwed into the tapped hole (40a). Grooves formed on the screw shaft (43) and the V-grooves in the row of grooves (15) formed on the grooved rods (12a) and (12b) are formed at the same pitch in the Y direction spirally. The screw shaft (43) is extended to the Y direction in parallel to the rotating shaft (32) and is supported rotatably by a bearing not shown. A gear (44) is mounted with an end of the screw shaft (43).

In Fig. 3, numeral (50) denotes a driving unit for driving the holding member rotating unit (30) and the wire feeding members (40). The driving unit (50) includes a gear (45), a driven pulley (toothed pulley) (46) having the same rotating axis as that of the gear (45), the motor (34), a driving pulley (48) mounted to an output shaft of the motor (34), and a toothed belt (47) for coupling the driven pulley (46) and the driving pulley (48).

The gear (44) and gear (45) have the same number of teeth and the gear (44) is meshed with the gear (45). The pitch circles of the gear (45) and the driven pulley (46) are the same and are also identical with the pitch circle of the driven pulley (33) mounted to the rotating shaft (32). The driven pulley (48) mounted to the output shaft of the motor (34) includes the same rotating shaft as that of the driving pulley (35). Further, since the driving pulley (48) and the driven pulley (46) are coupled by the toothed belt (47), both the pulleys (48) and (46) are rotated in synchronism with each other.

In the driving portion (50), the rotating shaft (32) is rotated to the direction and the screw shaft (43) is rotated to the β direction opposite to the a direction by means of motive power of the motor (34). However, the rotating shaft (32) and the screw shaft (43) arc rotated with the same rotational number. When the screw shaft (43) is rotated to the β direction, the movable table (40b) is moved to the Y (+) direction. Since the threaded grooves of the screw shaft (43) and the grooves in the row of grooves (15) are formed at the same pitch, the movement speed of the movable table (40b) is the same as the winding speed of the wire (L) to the Y direction onto the row of grooves (15) of the grooved rods (12a) and (12b).

The method of winding the wire (L) on the holding members (10) to complete the masking apparatus (M) and the method of using the masking apparatus (M) to evaporate thin film material on the surface of the board are now described.

First, the holding base (11), the grooved rods (12a) and (12b), the tension exerting member (21) and the hanging members (25) are assembled to form the holding members (10). The holding members (10) are mounted with the winding apparatus shown in Fig. 3 and screws are screwed into the mounting holes (25a) of the hanging members (25) to fixedly mount the hanging members (25) with the mounting brackets (31). Further, the raw wire roll (41) is loaded on the movable table (40b) of the wire feeding members (40). The wire (L) wound on the raw wire roll (41) is, for example, metal wire made of titanium and having a diameter of 0.22 mm or fiber made of heat-resisting resin.

The movable table (40b) of the wire feeding members (40) is first moved relatively to the holding members (10) toward the end on the side of Y (-). When the movable table (40b) is placed to this position, the wire (L) is pulled out from the raw wire roll (41) through the guide roll (42) and the starting end (La) of the wire (L) is fixed to the holding base (11) by the set screw (17). At this time, in the tension adjustment means (20) of the holding members (10), both the adjustment screws (23), (23) disposed at both ends in the Y direction are rotated to be screwed so that the brackets (22) and the tension exerting member (21) slightly approach the right surface (B side) of the holding base (11).

When the motor (34) is started, the holding members (10) are rotated together with the rotating shaft (32) and the mounting brackets (31) in the α direction. The screw shaft (43) is rotated to the β direction with the same rotational speed as that of the rotating shaft (32) in synchronism with the rotation of the holding members (10). When the screw shaft (43) is rotated to the β direction, the wire feeding members (40) is moved in the Y (+) direction, and since the holding members (10) are rotated to the a direction relatively to the wire feeding members (40), the wire (L) is wound spirally successively onto the row of grooves (15) of the grooved rods (12a) and (12b) disposed symmetrically on both the sides of the holding members (10).

More particularly, after the starting end (La) of the wire (L) is fixedly attached to the set screw (17), the wire (L) is pulled out to be put in the V-groove (15a) of the grooved rod (12a). Further, the wire (L) passes over the reverse surface (A surface) of the holding base (11) on which the board (1) is held and is put in the V-groove (15a) of the opposite grooved rod (12b). Then, the wire (L) passes over the right surface (B side) of the holding base (11) and is put on the tension exerting member (21). Further, the wire (L) is put in the V-groove (15a) of the grooved rod (12a) adjacent to the first V-groove (15a). This operation is repeated so that the wire (L) is wound in the V-grooves (15a) and suspended between the grooved rods (12a) and (12b) spirally.

When the screw shaft (43) is further rotated, the movable table (40b) is moved and finally the winding of the wire (L) on the holding members (10) is completed. When the winding of the wire (L) on the holding members (10) is completed, the motor (34) is stopped. Then, the termination end (Lb) of the wire (L) is fixed on the holding base (11) by the set screw (18) shown in Fig. 1 and the wire (L) is cut.

As described above, the winding of the wire (L) on the holding members (10) is completed. Thereafter, the adjustment screws (23) of the tension adjustment means (20) is loosened. In this manner, by loosening the adjustment screws (23), the resilient force is given to the tension exerting member (21) by means of the compression springs (24) so that the tension exerting member (21) is separated from the right surface (B side) of the holding base (11). The adjustment screws (23) are loosened, for example, by about 3 mm in term of the dimension to the axial direction of the adjustment screws (23). In this manner, by adjusting the tension by means of the tension exerting member (21), the wire (L) wound spirally on the grooved rods (12a) and (12b) is pushed up resiliently to the Z direction by the tension exerting member (21) to thereby increase the tension of the wire (L). Accordingly, the wire (L) is stretched by a relatively strong tension and the center of the wire (L) is positioned exactly in the valley at the center of the V-groove (15a) formed in the grooved rods (12a) and (12b) as shown in Fig. 5.

The grooved rods (12a) and (12b) are fixed on the ends of the holding base (11) in the X direction and the tension exerting member (21) is mounted with the right side (B side) of the holding base (11) at the place of the holding members (10) different from the mounted place of both the grooved rods (12a) and (12b). Accordingly, when the adjustment screws (23) are loosened to increase the tension of the tension exerting member (21), the grooved rods (12a) and (12b) are not moved and the V-grooves (15a) are not moved from the original position thereof. Accordingly, when the tension of the tension exerting member (21) is increased, the wire (L) is not get out of the V-grooves (15a) and the position of the wire (L) is stabilized. Accordingly, change from the winding process of the wire (L) to the adjustment process of the tension of the wire (L) by the tension exerting member (21) can be made easily. Further, the tensioned wire (L) is held exactly in the V-grooves (15a) and is stretched on the holding members (10) stably.

As shown in the sectional view of Fig. 5, the individual grooves constituting the row of grooves (15) are the V-grooves (15a) having the V-shaped section and the center of the tensioned wire (L) is positioned in the apexes of the V-grooves (15a). Thus, the wire (L) is positioned exactly in the row of grooves (15). Accordingly, the pitch (P) of the wire (L) put on the reverse surface (A side) of the holding base (11) is determined with high accuracy. Further, since the individual grooves constituting the row of grooves (15) are the V-grooves (15a), the pitch (P) of the wire (L) is determined by the pitch of the V-grooves (15a) with high accuracy.

As described above, the tension of the wire (L) is adjusted and manufacturing of the masking apparatus (M) is completed. The completed masking apparatus (M) is removed from the mounting brackets (31). Thus, as shown in Fig. 2, the board (1) made of insulative material such as glass is inserted into the cavity (11a) in the reverse surface (A) of the holding base (11) from the Y direction. Further, the holding plate (13) is inserted into the cavity (11a) and is fixedly mounted on the cavity (11a) by means of the fixing screws (14). When the board (1) is firmly held not to get out of holding base (11), the wire (L) can be wound spirally by the winding apparatus shown in Fig. 3 while the board (1) is held in the holding members (10). Alternatively, the board (1) may be loaded on the cavity (11a) before the winding of the wire (L) is completed, and then the tension of the wire (L) is increased after the winding of the wire (L) is completed.

Then, as shown in Fig. 4, the hanging members (25) of the masking apparatus (M) are attached to a mounting place (55) of the chamber of the vacuum evaporation apparatus and the holding base (11) is disposed so that the reverse surface (A side) thereof is directed downward to be opposite to the evaporation source. SiO2 of transparent or semi transparent optical material is evaporated from the lower position of Fig. 4 in the chamber. The optical material is evaporated onto the surface of the board (1) while using the wire (L) arranged at a fixed pitch (P) as the mask. Consequently, as shown in Fig. 5, the striped pattern (2) of thin film material having mountains and valleys arranged regularly at substantially the same pitch as the pitch (P) of the wire (L) is formed on the surface of the board (1). Since the wire (L) is stretched to be put in the V-grooves (15a) so that the pitch (P) of the wire (L) is set with high accuracy, the accuracy of the pitch of the mountains and the valleys of the striped pattern (2) is increased in accordance with the pitch of the wire (L).

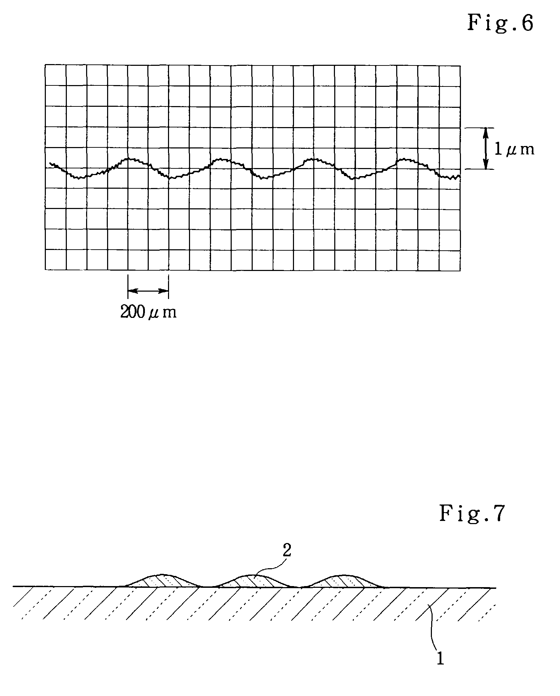

After completion of the evaporation, the holding plate (13) shown in Fig. 2 is taken out from the holding base (11) and the board (1) having the striped pattern (2) formed thereon is taken out from the masking apparatus (M). Fig. 7 shows the section of the striped pattern (2) formed on the board (1).

In the above example of structure, the board (1) is made of glass and the striped pattern (2) is made of SiO2, while other material may be used. Further, the board (1) may be rectangular or square. Furthermore, in the winding operation shown in Fig. 3, the holding members (10) may be fixed and the wire feeding members (40) may be rotated about the axis center (O) of the holding members (10) to thereby wind the wire (L) on the holding members (10) spirally. In addition, the wire feeding members may be installed not to be moved to the Y direction and the holding members (10) rotated relatively may be moved in the Y direction in synchronism with the pitch of the V-grooves (15a).

As described above, in the present invention, in the holding members (10) constituting the masking apparatus (M), the grooved rods (12a) and (12b) on which the wire (L) is wound are fixed on both the ends of the holding base (11) to the X direction. The row of grooves (15) is formed in the grooved rods (12a) and (12b) to put the wire (L) therein. The tension exerting member (21) for exerting the tension on the wire (L) stretched between the grooved rods (12a) and (12b) are disposed on the place different from the place that grooved rods (12a) and (12b). Accordingly, when the tension of the wire (L) is increased by the tension exerting member (21), the wire (L) is not get out of the row of grooves (15) and is stretched exactly between the grooved rods (12a) and (12b) in the state where the wire (L) is positioned exactly at the fixed pitch. Further, by forming the individual grooves constituting the row of grooves (15) into the V or U shape in section, the pitch of the wire (L) can be made constant more exactly. In addition, even if the diameter of the wire (L) is varied, the pitch of the wire (L) can be always determined to be disposed at equal intervals.

Further, by disposing the row of grooves (15) symmetrically on the grooved rods (12a) and (12b) and putting the single wire (L) in the row of grooves (15) to wind the wire thereon spirally, the tension of the wire (L) can be adjusted simply. Particularly, by moving the wire feeding members (40) in accordance with the pitch of the individual V-grooves (15a) of the row of grooves (15) and winding the wire (L) in the row of grooves (15) spirally, the wire (L) can be wound in the row of grooves (15) exactly without error.

Further, the masking apparatus (M) of the present invention can be used repeatedly without removing the wire (L) as it is and by removing the thin film material applied to the wire (L) when the evaporation is completed once, the masking apparatus (M) can use in the next evaporation process as it is. Furthermore, by coating on the wire (L) with oil used in the oil masking method, it is pretended that thin film materials puts on the surface of the wire (L), therefore the masking apparatus can be used repeatedly as it is.

In addition, thin film of optical material may previously formed on the surface of the board (1) with a uniform thickness and may be then removed by the dry etching method such as the ion etching method while using the wire (L) as the mask, so that the striped pattern (2) made of thin film material may be formed at the fixed pitch.

The present invention is now described in detail with reference to embodiments. The present invention is not limited to the embodiments.

### EXAMPLE

The masking apparatus (M) of the present invention described above was used to form the striped pattern (2) on the board (1) by the above evaporation method.

Titanium wire having the diameter of 0.22 mm was used as the wire (L). Unified screws formed with the row of grooves (15) having the V-grooves (15a) formed at the pitch of 0.434 mm to the Y(+) direction clockwise spirally were used as the grooved rods (12a) and (12b). A tension bar having the diameter of 8 mm was used as the tension exerting member (21). When the wire (L) was wound in the V-grooves (15a) of the grooved rods (12a) and (12b) spirally, the wire (L) was arranged on the reverse surface (A side) of the holding base (11) at the pitch of 0.434 mm at equal intervals. The wound range of the wire (L) was 80 mm in the width to the Y direction.

Then, the adjustment screws (23) of the tension adjustment means (20) was loosened by 3 mm to the axial direction thereof to increase the tension applied to the wire (L) by the tension exerting member (21).

A plate of glass (material: BK-7) having the diameter of 80 mm and the thickness of 5 mm was used as the board (1) and the board (1) was mounted to the holding base (11) after the tension applied to the wire (L) was increased as described above.

When the process proceeded to the evaporation process shown in Fig. 4, the board (1) was previously heated by radiant heat to raise the temperature of the board (1) to about 300C in order to increase adhesive force of SiO2 of thin film material to the board (1) and thereafter SiO2 was evaporated.

After evaporating board (1) was taken out from the masking apparatus (M) and the striped pattern (2) formed from thin film by the evaporation was evaluated.

In the evaluation, a probe-type surface roughness meter was used to measure roughness of the surface of the striped pattern. Fig. 6 shows the measured result. The abscissa represents distance in the Y direction on the surface of the board (1) and the ordinate represents height of ruggedness or roughness on the surface of the board (1) (height of the mountain and the valley of the striped pattern (2)). In the graph of Fig. 6, the length for two' boxes in the horizontal direction and the length for two boxes in the vertical direction represent one division (10 mm) of the graph graduated in every 10 mm. One division in the horizontal direction represents 200 mm in the distance of the board (1). Further, the one division in the vertical direction represents 1 mm in the height of the ruggedness on the surface of the board (1).

According to the measured result, the pitch of mountains and valleys of the striped pattern on the surface was 0.46 mm. This pitch is longer than the pitch of 0.434 mm of the V-grooves (15a) of the grooved rods (12a) and (12b), while this is considered to be caused by thermal expansion of the grooved rods (12a) and (12b) in the axial direction thereof due to radiant heat in previous heating of the board (1) and heat in the evaporation process. The average roughness Ra in a center line of ruggedness of the striped pattern (2) was 0.14 mm and the maximum height Rmax was 0. 68 mm.

The striped pattern (2) has the pitch of mountains and valleys formed uniformly with extremely high accuracy and the characteristics as an optical low pass filter are satisfactory.

## Claims

1. A method of forming striped pattern of thin film material on the surface of a board, comprising:
using holding members including a holding base having one surface on which the board is disposed and a pair of shaft members fixedly mounted in both ends of said holding base in parallel with each other and having a plurality of grooves having V- or U-shaped section formed at an equal pitch in the axial direction;
a process of winding a wire around the surface of said holding base at a fixed pitch by putting the wire in the grooves of said pair of shaft members in order spirally by repeating the following operation including putting the wire in a groove of one of said shaft members, passing the wire on one surface of said holding base, putting the wire in a groove of the other shaft member, passing the wire on the other surface of said holding base and putting the wire in a groove of said one shaft member adjacent to the groove in which the wire has been put lastly;
a process of exerting resilient force on said wound wire to separate the wound wire from said holding base so that tension is exerted on the wound wire and completing winding of the wire on said holding members;
a process of installing a board between one surface of said holding base and the wound wire after or before the winding of the wire on said holding members has been completed;
a process of adhesively applying optical material on the surface of said board by evaporation while using the wound wire as a mask to form on the surface of said board the striped pattern of thin film optical material having mountains and valleys corresponding to a pitch of the wound wire; and
a process of taking out said board from said holding base after formation of said striped pattern of thin film optical material on the surface of said board.

2. A method of forming striped pattern of thin film material on the surface of a board, according to Claim 1, comprising:
a process of rotating said holding members about an axis positioned in parallel to said pair of shaft and in the middle of said pair of shaft members relatively to a wire feeding members; and
a step of moving said holding members and said wire feeding members relatively to the parallel direction to said shaft members at a speed of movement by one pitch of the grooves on said shaft members per said rotation of holding members rotation
and putting the wire in grooves of said pair of shaft members successively to wind the wire on said holding members at a fixed pitch spirally.

3. A masking apparatus comprising:
holding members including
a holding base having one surface on which a board is disposed
and a pair of shaft members fixed on both ends of said holding base in parallel to each other and having a plurality of grooves having V- or U-shaped section formed at an equal pitch in the axial direction;
a tension exerting member disposed in a place different from places where said shaft members of said holding members are fixed on and on which resilient force is exerted so that said tension exerting member is separated from said holding base; and
wire put in said grooves of said pair of shaft members to be suspended between said pair of shaft members so that said wire is wound spirally on said surface of said holding base on which said board is disposed and said tension exerting member to pass through thereon;
whereby said wire is opposite to the surface of said board at a fixed pitch when said board is held on the surface of said holding base.

4. A masking apparatus according to Claim 3, wherein said shaft members fixed on said holding base includes grooves each having V-or U-shaped section formed and formed at the equal pitch in the axial direction spirally.

5. A masking apparatus according to Claim 3, wherein said tension exerting member includes a pair of springs disposed in the center between said pair of shaft members and in parallel to said shaft members on an opposite surface of said holding base to said surface on which said board is disposed and for exerting resilient force on said tension exerting member so that said tension exerting member is separated from said holding base,
and adjustment members for moving said tension exerting member toward said holding base against the resilient force of said springs.

6. A masking apparatus according to Claim 3, comprising a cavity formed in said surface of said holding base on which said board is disposed, said cavity being opened to a side end of said holding base so that said board can pass through said side end to be inserted between said wire and said cavity.
